# EUROPEAN PATENT APPLICATION

(11) **EP 4 583 166 A1**
(43) Date of publication of application: **09.07.2025**
(21) Application number: 24150557.7
(22) Date of filing: 05.01.2024
(51) Int. Cl.: H01L 29/06, H01L 29/10, H01L 21/337, H01L 29/808, H01L 29/16

(54) **BI-DIRECTIONAL JUNCTION FIELD-EFFECT TRANSISTOR**

(71) Applicant: Infineon Technologies Austria AG, 9500 Villach (AT)
(72) Inventor: POPESCU, Dan Horia, 81245 München (DE); POPESCU, Bogdan Vlad, 81245 München (DE)
(74) Representative: Müller Hoffmann & Partner

(57) **Abstract**

A bi-directional junction field-effect transistor, bi-directional JFET (100) is proposed. The bi-directional JFET (100) includes a semiconductor substrate (102) having a first surface (1021) and a second surface (1022) opposite to the first surface (1021). The semiconductor substrate (102) includes a first drift structure (104) comprising a drift region (1041) of a first conductivity type. The semiconductor substrate (102) further includes a channel region (106) of the first conductivity type adjoining, along a first lateral direction (x1), to first and second sub-regions (1081, 1082) of a control region (108) of a second conductivity type. The semiconductor substrate (102) further includes a second drift structure (110) comprising a drift region (1101) of the first conductivity type. The channel region (106) and the first and second sub-regions (1081, 1082) of the control region (108) are arranged, along a vertical direction (y), between the first drift structure (104) and the second drift structure (110).

## Description

### TECHNICAL FIELD

The present disclosure is related to a semiconductor device, in particular to a bi-directional junction field effect transistor, bi-directional JFET.

### BACKGROUND

Technology development of new generations of semiconductor devices, e.g. junction field effect transistors (JFETs), aims at improving electric device characteristics and reducing costs by shrinking device geometries. Although costs may be reduced by shrinking device geometries, a variety of tradeoffs and challenges have to be met when increasing device functionalities per unit area. For example, bi-directionality of power semiconductor switches is challenging in view of active area consumption and requires design optimization.

Thus, there is a need for an improved junction field effect transistor.

### SUMMARY

An example of the present disclosure relates to a bi-directional junction field effect transistor, bi-directional JFET. The bi-directional JFET includes a semiconductor substrate having a first surface and a second surface opposite to the first surface. The semiconductor substrate includes a first drift structure comprising a drift region of a first conductivity type. The semiconductor substrate further includes a channel region of the first conductivity type adjoining, along a first lateral direction, to first and second sub-regions of a control region of a second conductivity type. The semiconductor substrate further includes a second drift structure comprising a drift region of the first conductivity type. The channel region and the first and second sub-regions of the control region are arranged, along a vertical direction, between the first drift structure and the second drift structure.

Another example of the present disclosure relates to a method of manufacturing a bi-directional junction field-effect transistor, bi-directional JFET. The method includes forming, in a semiconductor substrate having a first surface and a second surface opposite to the first surface, a first drift structure comprising a drift region of a first conductivity type. The method further includes forming a channel region of the first conductivity type adjoining, along a first lateral direction, to first and second sub-regions of a control region of a second conductivity type. The method further includes forming a second drift structure comprising a drift region of the first conductivity type. The channel region and the first and second sub-regions of the control region are arranged, along a vertical direction, between the first drift structure and the second drift structure.

Those skilled in the art will recognize additional features and advantages upon reading the following detailed description, and upon viewing the accompanying drawings.

### BRIEF DESCRIPTION OF THE DRAWINGS

The accompanying drawings are included to provide a further understanding of the embodiments and are incorporated in and constitute a part of this specification. The drawings illustrate examples of bi-directional JFETs and together with the description serve to explain principles of the examples. Further examples are described in the following detailed description and the claims.
Figs. 1 and 2 are schematic and exemplary cross-sectional views for illustrating configuration examples of bi-directional JFETs having a mesa channel region confined by a control region.
Figs. 3A to 3D are schematic cross-sectional views for illustrating process features of forming a superjunction structure in a first drift structure of a bi-directional JFET.
Figs. 4A to 4C are schematic cross-sectional views for illustrating process features of forming a control region and a channel region of a bi-directional JFET.
Fig. 5 is a schematic and exemplary cross-sectional view for illustrating a configuration example of a bi-directional JFET having a superjunction structure in a first drift structure.
Figs. 6 and 7 are schematic cross-sectional views for illustrating contact trench structures for electrically connecting the control region of a bi-directional JFET.
Fig. 8 is a schematic cross-sectional view for illustrating an intermediate tap trench structure for electrically connecting the channel region of a bi-directional JFET.
Figs. 9A to 9C are schematic illustrations of different operation modes of a bi-directional JFET.

### DETAILED DESCRIPTION

In the following detailed description, reference is made to the accompanying drawings, which form a part hereof and in which are shown by way of illustrations specific examples of bi-directional JFETs. It is to be understood that other examples may be utilized and structural or logical changes may be made without departing from the scope of the present disclosure. For example, features illustrated or described for one example can be used in conjunction with other examples to yield yet a further example. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" describes a permanent low-resistive connection between electrically connected elements, for example a direct contact between the concerned elements or a low-resistive connection via a metal and/or heavily doped semiconductor material. The term "electrically coupled" includes that one or more intervening element(s) adapted for signal and/or power transmission may be connected between the electrically coupled elements, for example, elements that are controllable to temporarily provide a low-resistive connection in a first state and a high-resistive electric decoupling in a second state. An ohmic contact is a non-rectifying electrical junction.

Ranges given for physical dimensions include the boundary values. For example, a range for a parameter y from a to b reads as a ≤ y ≤ b. The same holds for ranges with one boundary value like "at most" and "at least".

The terms "on" and "over" are not to be construed as meaning only "directly on" and "directly over". Rather, if one element is positioned "on" or "over" another element (e.g., a layer is "on" or "over" another layer or "on" or "over" a substrate), a further component (e.g., a further layer) may be positioned between the two elements (e.g., a further layer may be positioned between a layer and a substrate if the layer is "on" or "over" said substrate).

An example of a bi-directional junction field-effect transistor, bi-directional JFET includes a semiconductor substrate having a first surface and a second surface opposite to the first surface. The semiconductor substrate includes a first drift structure comprising a drift region of a first conductivity type. The semiconductor substrate further includes a channel region of the first conductivity type adjoining, along a first lateral direction, to first and second sub-regions of a control region of a second conductivity type. The semiconductor substrate further includes a second drift structure comprising a drift region of the first conductivity type. The channel region and the first and second sub-regions of the control region are arranged, along a vertical direction, between the first drift structure and the second drift structure.

The bi-directional JFET is configured to block voltages in both directions. In other words, the bi-directional JFET enables a blocking voltage behavior for positive and negative voltages applied between load terminals, e.g. first and second load electrodes, of the device.

The first lateral direction may be a transverse direction of the channel region and may be perpendicular to a second lateral direction. The second lateral direction may be a longitudinal direction of the channel region, for example. For example, a width of the channel region may be measured along the first lateral direction, for example.

The bi-directional JFET may be part of an integrated circuit or may define a discrete semiconductor device or a semiconductor module, for example. For example, the bi-directional JFET may be a bi-directional trenched and implanted vertical-channel JFET, bi-directional TI-VJFET. In a bi-directional vertical-channel JFET, a load current flow is between a first load electrode or contact over the first surface of the semiconductor substrate and a second load electrode or contact over a second surface opposite to the first surface along a vertical direction. In the bi-directional vertical-channel JFET, a load current may flow along the vertical direction perpendicular to the first and/or second surface.

The first surface may be a front surface or a top surface of the semiconductor substrate, and the second surface may be a back surface or a rear surface of the semiconductor substrate, for example. For example, the semiconductor substrate may be attached to a lead frame via the second surface, for example. Over the first surface of the semiconductor body, bond pads may be arranged and bond wires may be bonded on the bond pads, for example.

The semiconductor substrate may include or consist of a semiconductor material from the group IV elemental semiconductors, IV-IV compound semiconductor material, III-V compound semiconductor material, or II-VI compound semiconductor material. Examples of semiconductor materials from the group IV elemental semiconductors include, inter alia, silicon (Si) and germanium (Ge). Examples of IV-IV compound semiconductor materials include, inter alia, silicon carbide (SiC) and silicon germanium (SiGe). Examples of III-V compound semiconductor material include, inter alia, gallium arsenide (GaAs), gallium nitride (GaN), gallium phosphide (GaP), indium phosphide (InP), indium gallium nitride (InGaN) and indium gallium arsenide (InGaAs). Examples of II-VI compound semiconductor materials include, inter alia, cadmium telluride (CdTe), mercury-cadmium-telluride (CdHgTe), and cadmium magnesium telluride (CdMgTe). For example, the semiconductor substrate may be a crystalline SiC semiconductor base substrate having none, one or more SiC layers formed thereon. For example, the silicon carbide crystal may have a hexagonal polytype, e.g., 4H or 6H. The silicon carbide semiconductor substrate may be homogeneously doped or may include differently doped SiC layer portions. The silicon carbide semiconductor substrate may include one or more layers from another material. For example, the layers from another material may be embedded in the crystalline silicon carbide substrate. The silicon carbide semiconductor substrate may have two essentially parallel main surfaces of the same shape and size and a lateral surface area connecting the edges of the two main surfaces.

The bi-directional JFET may be configured to conduct currents of more than 1A or more than 10 A or even more than 100 A. For example, the bi-directional JFET may be designed as a transistor cell array of a plurality of transistor cells having a same or similar layout. The transistor cell array may be a 1-dimensional or a 2-dimensional regular arrangement of the plurality of transistor cells. For example, the plurality of transistor cells of the transistor cell array may be electrically connected in parallel. For example, first load terminals of the plurality of transistor cells of the bi-directional JFET transistor cell array may be electrically connected together. Likewise, second load terminals of the plurality of transistor cells of the bi-directional JFET transistor cell array may be electrically connected together. For example, control (gate) regions of the plurality of transistor cells of the trench JFET transistor cell array may be electrically connected together. A transistor cell of the transistor cell array or a part thereof, e.g. the mesa region including the channel region, may be designed in the shape of a stripe, a polygon, a circle or an oval, for example.

A number of transistor cells of the transistor cell array may depend on the maximum load current, for example. For example, a number of transistor cells of the transistor cell array may be larger than 100, or larger than 1000, or even larger than 10000, for example. The bi-directional JFET may be further configured to block voltages between the load electrodes of the bi-directional JFET of more than 60V, 100V, 400 V, 650V, 1.2kV, 1.7kV, 3.3kV, 4.5kV, 5.5kV, 6kV, 6.5kV, 10kV. The blocking voltage may correspond to a voltage class specified in a datasheet of the bi-directional JFET, for example. The blocking voltage of the bi-directional JFET may be adjusted for a first polarity such as a negative voltage at the first load electrode with respect to the second load electrode, by an impurity concentration and/or a vertical extension of the drift region of the first drift structure. A doping concentration of the drift region of the first drift structure may vary along a lateral and/or vertical direction, e.g. vary gradually or in steps increase or decrease with increasing distance to the first surface at least in portions of its vertical extension. Likewise, the blocking voltage of the bi-directional JFET may be adjusted for a second polarity such as a positive voltage at the first load electrode with respect to the second load electrode, by an impurity concentration and/or a vertical extension of the drift region of the second drift structure. In case of superjunction devices, the doping type may vary, e.g. alternate, along the first lateral direction, for example. According to other examples the impurity concentration in the drift zone may be approximately uniform. For bi-directional JFETs based on silicon, a mean impurity concentration in the drift region of the first and/or drift structure may be between 2 × 10¹² cm⁻³ and 1 × 10¹⁷ cm⁻³, for example in a range from 5 × 10¹² cm⁻³ to 1 × 10¹⁵ cm⁻³ or to 2 × 10¹⁵ cm⁻³. In the case of a bi-directional JFETs based on SiC, a mean impurity concentration in the drift region of the first and/or second drift structure may be between 5 × 10¹⁴ cm⁻³ and 1 × 10¹⁷ cm⁻³, for example in a range from 1 × 10¹⁵ cm⁻³ to 5 × 10¹⁶ cm⁻³. When operating the bi-directional JFET in voltage blocking mode, a space charge region may vertically extend partly or totally through the drift region of the first or second drift structure depending on the blocking voltage and polarity applied to the bi-directional JFET. Since the drift regions of the first and second drift structures may be designed independent from one another, asymmetric voltage blocking behavior of the bi-directional JFET may be adapted to the needs of the specific case.

The first load electrode may be part of a wiring area over the first surface of the semiconductor substrate. The wiring area may include one or more than one, e.g. two, three, four or even more wiring levels. Each wiring level may be formed by a single one or a stack of conductive layers, e.g. metal layer(s). The wiring levels may be lithographically patterned, for example. Between stacked wiring levels, an interlayer dielectric structure may be arranged. Contact plug(s) or contact line(s) may be formed in openings in the interlayer dielectric structure to electrically connect parts, e.g. metal lines or contact areas, of different wiring levels to one another. The first load electrode may be formed by one or more elements of the wiring area over the first surface. Likewise, the second load electrode may be formed by one or more elements of the wiring area over the second surface. For example, the wiring area over the second surface may include one or a stack of metal layers.

The bi-directional JFETs described herein may allow for an improvement in the area-specific on-state resistance RonxA. In view of integration of bi-directional device functionality in a single device by stacking of the first and second drift structures, contribution of substrate resistance and contact resistance can be reduced compared with a configuration based on two separate devices.

For example, the bi-directional JFET may include a first load electrode over the first surface of the semiconductor substrate. The first load electrode may be electrically connected to the second drift structure. The bi-directional JFET may further include a second load electrode over the second surface of the semiconductor substrate. The second load electrode may be electrically connected to the first drift structure.

For example, the first drift structure may further include a compensation region of the second conductivity type. The compensation region may be electrically connected to the first and second sub-regions of the control region. The compensation region and the drift region of the first drift structure may form a superjunction structure, SJ structure. For example, the compensation region may be configured to be fully depleted when operating the device in a reverse-bias mode.

For example, the first subregion may be connected to the second subregion via a third sub-region of the control region. The first sub-region, the second sub-region, and the third sub-region may define U-shaped control region. The third sub-region may define a bottom part of the U-shaped control region that may be oriented toward the second surface of the semiconductor substrate.

For example, the bi-directional JFET may further include an intermediate region of the first conductivity type arranged between the first sub-region and the second sub-region of the control region along the first lateral direction.

For example, the bi-directional JFET may further include a control contact trench structure extending from the first surface through the second drift structure. The third sub-region of the control region may be electrically connected to a contact material of the control contact trench structure via a bottom of the control contact trench structure.

For example, the control contact trench structure may include the contact material and a dielectric fill material on the contact material.

For example, the contact material may include a metal or a metal silicide at a bottom of the control contact trench structure. Depending on the conductivity type of semiconductor region to be electrically connected, e.g. n-doped or p-doped region, the contact region may further include a highly doped intermediate region of the same conductivity type, for example. This may enable a better ohmic contact to the contact material of the control contact trench structure, for example.

For example, the channel region may extend along a second lateral direction perpendicular to the first lateral direction. A plurality of the control contact trench structures may be arranged with a lateral distance along the second lateral direction. By varying dimensions and arrangement pattern of the control contact trench structures, device behavior, e.g. dynamic switching behavior, may be adjusted.

For example, the second drift structure may further include a compensation region of the second conductivity type lining sidewalls of the control contact trench structure.

For example, the bi-directional JFET may further include an intermediate tap trench structure extending from the first surface through the second drift structure. The channel region may be electrically connected to a contact material of the intermediate tap trench structure via a bottom of the intermediate tap trench structure. For example, the intermediate tap trench structure may include the contact material and a dielectric fill material on the contact material. For example, the contact material may include a metal or a metal silicide at a bottom of the intermediate tap trench structure. Depending on the conductivity type of semiconductor region to be electrically connected, e.g. n-doped or p-doped region, the contact region may further include a highly doped intermediate region of the same conductivity type, for example. This may enable a better ohmic contact to the contact material of the intermediate tap trench structure, for example.

For example, the second drift structure may further include an enhancement region of the first conductivity type lining sidewalls of the intermediate tap trench structure. The enhancement region of the second drift structure may have a larger doping concentration than the drift region of the second drift structure. The enhancement region may allow for compensating the loss in drift region conductivity caused by the area consumption of the contact trench structures, for example. As an alternative to the enhancement region or in addition to the enhancement region, the second drift structure may further include a compensation region of the second conductivity type lining sidewalls of the intermediate tap trench structure. This may allow for increasing a doping concentration of the drift region of the second drift structure based on a SJ structure in the second drift structure. Also this measure may allow for compensating the loss in drift region conductivity caused by the area consumption of the intermediate tap trench structures, for example.

For example, along the first lateral direction, the channel region may include first, second and third channel sub-regions having a same extent along the first lateral direction. A concentration of dopants of the first conductivity type averaged along the first lateral direction in the second channel sub-region may be larger than a concentration of dopants of the first conductivity type averaged along the first lateral direction in each of the first and third channel sub-regions.

Details with respect to structure, or function, or technical benefit of features described above with respect to a bi-directional JFET likewise apply to the exemplary methods described herein. Processing the semiconductor substrate may comprise one or more optional additional features corresponding to one or more aspects mentioned in connection with the proposed concept or one or more examples described above or below.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof. It is to be understood that the disclosure of multiple acts, processes, operations, steps or functions disclosed in the specification or claims may not be construed as to be within the specific order, unless explicitly or implicitly stated otherwise, e.g. by expressions like "thereafter", for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, - processes, -operations or-steps, respectively. Such sub acts may be included and part of the disclosure of this single act unless explicitly excluded.

An example of the present disclosure relates to a method of manufacturing a bi-directional junction field-effect transistor, bi-directional JFET. The method may include forming, in a semiconductor substrate having a first surface and a second surface opposite to the first surface, a first drift structure comprising a drift region of a first conductivity type. The method may further include forming a channel region of the first conductivity type adjoining, along a first lateral direction, to first and second sub-regions of a control region of a second conductivity type. The method may further include forming a second drift structure comprising a drift region of the first conductivity type. The channel region and the first and second sub-regions of the control region may be arranged, along a vertical direction, between the first drift structure and the second drift structure.

For example, forming the first and second sub-regions of the control region may include forming a trench into a first semiconductor layer of the semiconductor substrate. The first semiconductor layer includes the first drift structure. The method may further include introducing dopants of the second conductivity type into the first semiconductor layer through sidewalls of the trench.

For example, the channel region may be part of the first semiconductor layer that laterally adjoins to the first and second sub-regions of the control region. Forming the channel region may further include introducing dopants of the first conductivity type into the part of the first semiconductor layer through sidewalls of the trench.

For example, the second drift structure may be formed by an epitaxial deposition process of a second semiconductor layer on the first semiconductor layer after forming the first and second sub-regions of the control region.

The examples and features described above and below may be combined.

More details and aspects are mentioned in connection with the examples described above or below. The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

In the following, further examples of bi-directional JFETs are explained in connection with the accompanying drawings. Functional and structural details described with respect to the examples above shall likewise apply to the exemplary embodiments illustrated in the figures and described further below. In the illustrated examples, the first conductivity is n-type and the second conductivity type is p-type for an n-channel bi-directional JFET. However, the first conductivity type may also be p-type and the second conductivity type may be n-type for a p-channel trench JFET.

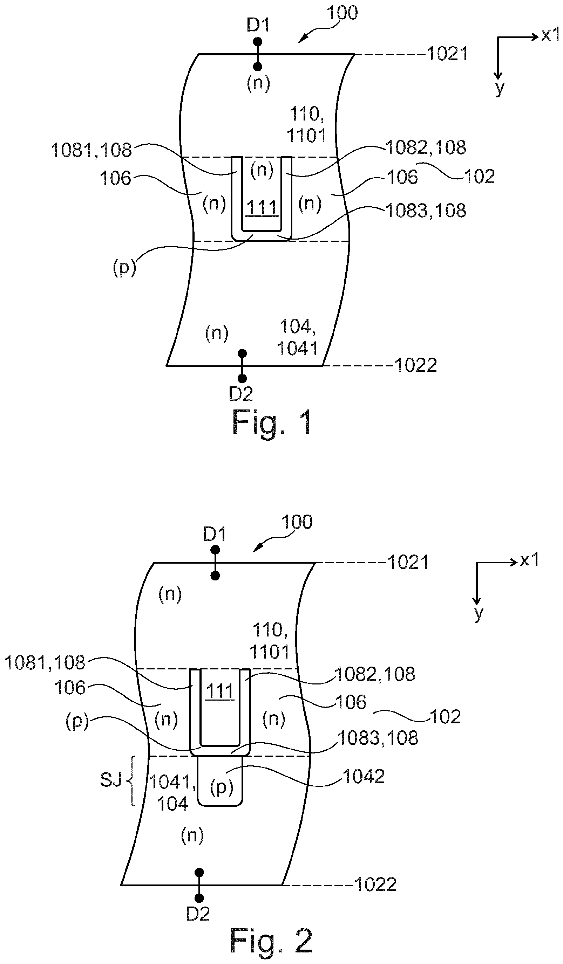

Fig. 1 schematically and exemplarily shows a cross-sectional view of a configuration example of a bi-directional JFET 100.

The bi-directional JFET 100 includes a semiconductor substrate 102, e.g. a SiC semiconductor substrate, having a first surface 1021, e.g. a front or top surface, and a second surface 1022, e.g. a rear or back surface, opposite to the first surface 1021.

A first drift structure 104 is included in a lower part of the semiconductor substrate 102 and includes an n-doped drift region 1041. For example, dopants in a semiconductor substrate based on SiC may include Al, B, Be, Ga, or any combination thereof for p-type doping, and N, P, or any combination thereof for n-type doping. Dopants in a semiconductor substrate based on Si may include Al, B, Ga, In, or any combination thereof for p-type doping, and P, As, Sb, hydrogen-related donors, or any combination thereof for n-type doping.

The first drift structure 104 is electrically connected to a second load electrode D2 via the second surface 1022 of the semiconductor substrate 102.

An n-doped a channel region 106 is arranged on the first drift structure 104. The n-doped channel region 106 adjoins, along a first lateral direction x1, to first and second sub-regions 1081, 1082 of a p-doped control region 108. The first subregion 1081 is connected to the second subregion 1082 via a third sub-region 1083 of the control region 108. The first sub-region 1081, the second sub-region 1082, and the third sub-region 1083 define a U-shaped p-doped control region 108. An n-doped intermediate region 111 is arranged between the first sub-region 1081 and the second sub-region 1082 of the control region 108 along the first lateral direction x1. By applying a control or gate voltage to the p-doped control region, a space charge region expands into the channel region 106 from opposite sides of the channel region 106 that may lead to a transistor turn-off due to pinch-off of the channel region 106, for example.

A second drift structure 110 including an n-doped drift region 1101 is arranged on the channel region 106. The channel region 106 and the first and second sub-regions 1081, 1082 of the control region 108 are arranged, along a vertical direction y, between the first drift structure 104 and the second drift structure 110.

Fig. 2 schematically and exemplarily shows a cross-sectional view of a configuration example of a bi-directional JFET 100 that is based on the device illustrated in Fig. 1.

The bi-directional JFET 100 illustrated in Fig. 2 further includes a p-doped compensation region 1042 as part of the first drift structure 104. The compensation region 1042 is electrically connected to the first and second sub-regions 1081, 1082 of the control region 108. The p-doped compensation region 1042 and the n-doped drift region 1041 of the first drift structure 104 form a superjunction structure, SJ structure. The SJ structure may allow for a further improvement of the tradeoff between area-specific on-state resistance and voltage blocking behavior of the device.

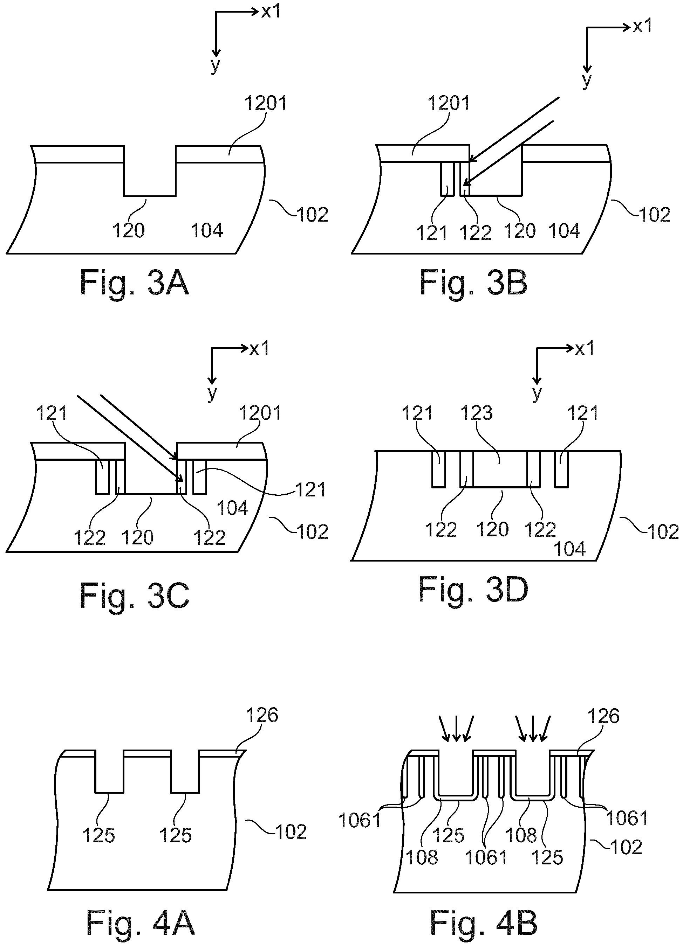

The schematic cross-sectional views of Figs. 3A to 3C illustrate exemplary process features for forming a SJ structure in the first drift structure 104.

Referring to Fig. 3A, a trench 120 is formed in a lightly doped or undoped semiconductor layer of the first drift structure 104 of the semiconductor substrate 102, e.g. by an etch process using a mask 1201.

Referring to Figs. 3B and 3C, n-type dopants 121 and p-type dopants 122 are introduced into the first drift structure 104 by one or more tilted ion implantations using the mask 1201 or another mask as an ion implantation mask.

Referring to Fig. 3D, the trench 120 may be filled with lightly doped or undoped semiconductor material 123. Depending on the diffusion characteristic of the n- and p-type dopants 121, 122 in the semiconductor substrate 102 and the subsequent thermal budget of processing the semiconductor substrate 102, the as-implanted profiles of the n- and p- type dopants 121, 122 along the first lateral direction x1 may broaden. This may lead to a partial overlap of the profiles of the n- and p-type dopants 121, 122, for example.

Based on the SJ structure as illustrated in Fig. 3D or based on an n-doped first drift structure 104 without a SJ structure, the channel region 106 and the control region 108 may be formed by process features as described with reference to Figs. 4A to 4C, for example.

Referring to Fig. 4A, a second trench 125 is formed in the semiconductor substrate 102, e.g. by an etch process using a mask 126.

Referring to Fig. 4B, the control region 108 is formed by p-type dopants introduced into the semiconductor substrate 102 by one or more tilted and/or non-tilted ion implantations using the mask 126 or another mask as an ion implantation mask.

A lateral doping concentration profile in the channel region 106 may be adjusted by introducing n-type dopants into the channel region 106 by one or more tilted ion implantations using the mask 126 or another mask as an ion implantation mask. The channel ion implantations may result in n-doped channel portions 1061. For example, along the first lateral direction x1, the channel region 106 may include first, second and third channel sub-regions having a same extent along the first lateral direction. A concentration of n-type dopants averaged along the first lateral direction x1 in the second channel sub-region may be larger than a concentration of n-type dopants averaged along the first lateral direction in each of the first and third channel sub-regions.

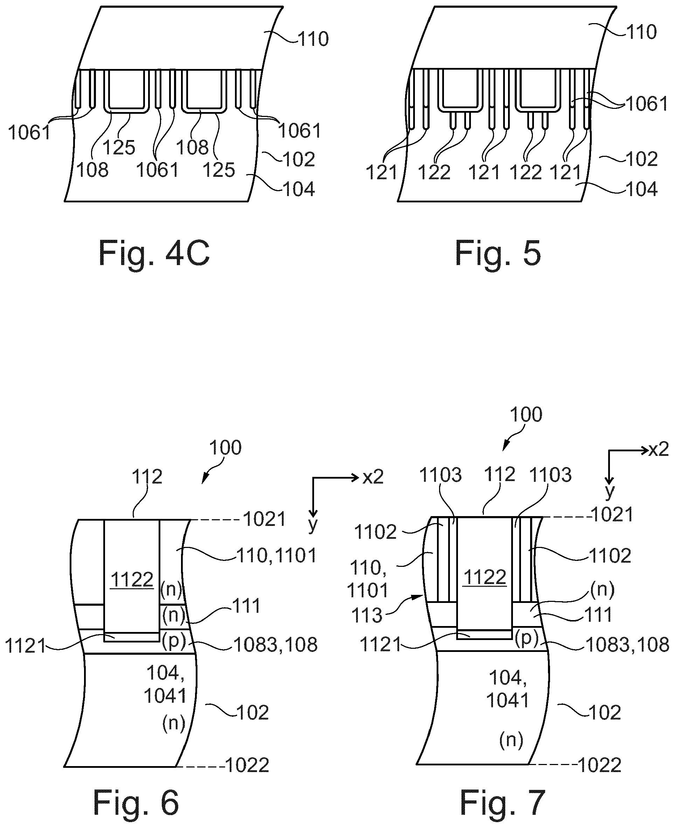

Referring to Fig. 4C, after removing the mask 126 and filling of the trench 125 with semiconductor material, e.g. n-doped semiconductor material, the second drift structure 110 is formed by an epitaxial deposition process of a second semiconductor layer.

In case a SJ structure is included in the first drift structure 104 (see, for example, Fig. 3C), the regions formed by the n- dopants 121 of the SJ structure in the first drift structure 104 may be connected to the n-doped channel portions 1061. The regions formed by the p- dopants 122 of the SJ structure in the first drift structure 104 may be connected to the control region 108 as is schematically illustrated in the schematic cross-sectional view of Fig. 5.

Referring to the schematic cross-sectional view of Fig. 6, the control region 108 may be electrically connected by a control contact trench structure 112 extending from the first surface 1021 through the second drift structure 110. The third sub-region 1083 of the control region 108 is electrically connected to a contact material 1121 of the control contact trench structure 112 via a bottom of the control contact trench structure 112. The contact material 1121 may include a p+-doped region extending into the third sub-region 1083 and a metal or metal silicide layer thereon. The control contact trench structure 112 is filled with a dielectric fill material 1122 that is arranged on the contact material 1121. An arrangement, e.g. dimensions and/or density, of the control contact trench structures 112 in a JFET transistor cell array may be adapted with respect to demands on the dynamic behavior of the device, for example. The control contact trench structure 112 may extend into an area outside of the JFET transistor cell array, e.g. into a gate runner area. In the area outside of the JFET transistor cell array, the dielectric fill material 1122 may be replaced by a conductive material for electrically connecting the contact material 1121 to a connection line, e.g. a gate runner line. The gate runner line may at least partly surround the JFET transistor cell array and turn into a control electrode, e.g. a gate pad.

Referring to the configuration example illustrated in the schematic cross-sectional view of Fig. 7, the second drift structure 110 further includes an n-doped region 1102 and a p-doped region (compensation region) 1103 lining sidewalls of the control contact trench structure 112 and forming a SJ region 113. The SJ region 113 may allow for compensating a loss in drift region conductivity caused by the area consumption of the control contact trench structures 112, for example. Fabrication steps may be analogous to lower SJ region (tilted trench sidewall implants).

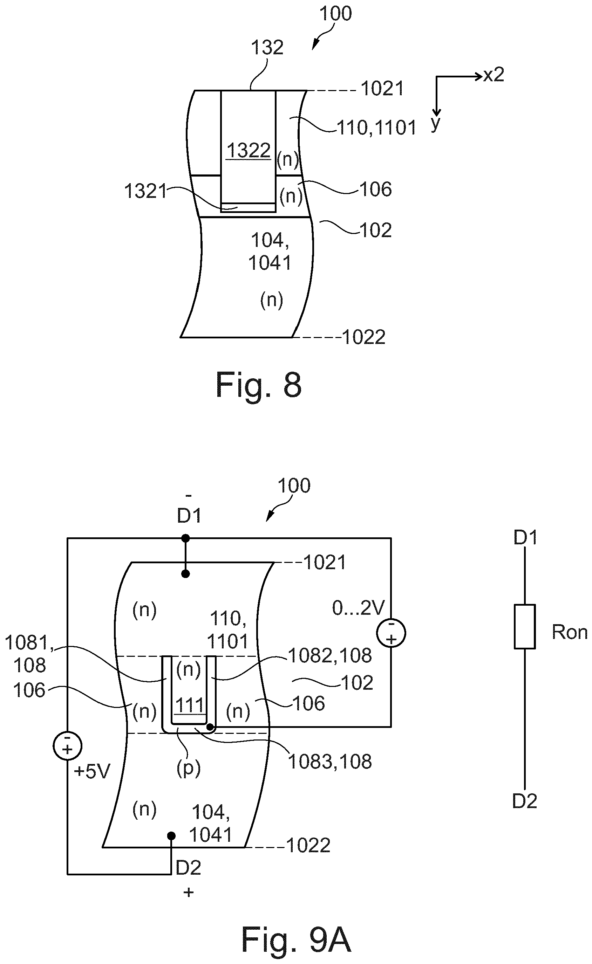

Referring to the schematic cross-sectional view of Fig. 8, the channel region 106 may be electrically connected by an intermediate tap trench structure 132 extending from the first surface 1021 through the second drift structure 110. The channel region 106 is electrically connected to a contact material 1321 of the intermediate tap trench structure 132 via a bottom of the intermediate tap trench structure 132. The contact material 1321 may include an n+-doped region extending into the channel region 106 and a metal or metal silicide layer thereon. The intermediate tap trench structure 132 is filled with a dielectric fill material 1322 that is arranged on the contact material 1321. The intermediate tap trench structure 132 may extend into an area outside of the JFET transistor cell array, e.g. into a source runner area. In the area outside of the JFET transistor cell array, the dielectric fill material 1322 may be replaced by a conductive material for electrically connecting the contact material 1121 to a connection line, e.g. a source runner or tap line. The tap line may at least partly surround the JFET transistor cell array and be electrically connected to a contact pad, source sense, for example.

Figures 9A to 9C are schematic illustrations for exemplifying different operation modes of a bi-directional JFET 100.

Referring to Fig. 9A, a positive voltage is applied to the second load electrode D2 with respect to the first load electrode D1, and a positive voltage is applied to the control region 108 with respect to the first electrode D1. Thereby, the bi-directional JFET 100 is turned on having an on-state resistance Ron for a load current flow between the first and second load electrodes D1, D2.

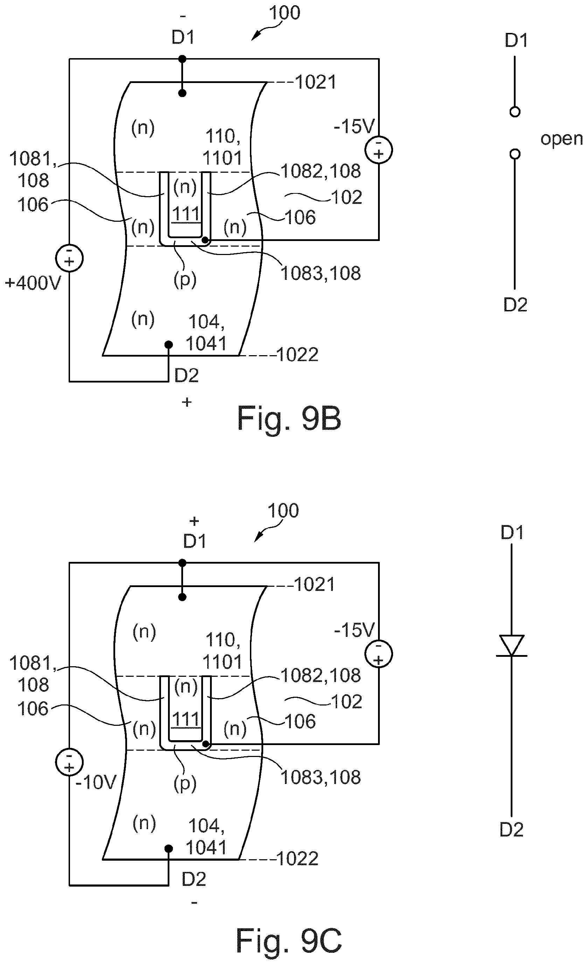

Referring to Fig. 9B, a high positive voltage is applied to the second load electrode D2 with respect to the first load electrode D1, and a negative voltage is applied to the control region 108 with respect to the first electrode D1. Thereby, the bi-directional JFET 100 is turned off having a blocking voltage drop over the first drift structure 104.

Referring to Fig. 9C, a negative voltage is applied to the second load electrode D2 with respect to the first load electrode D1, and a negative voltage is applied to the control region 108 with respect to the first electrode D1. Thereby, the bi-directional JFET 100 is operated in a diode mode.

The aspects and features mentioned and described together with one or more of the previously described examples and figures, may as well be combined with one or more of the other examples in order to replace a like feature of the other example or in order to additionally introduce the feature to the other example.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A bi-directional junction field-effect transistor, bi-directional JFET (100), comprising:
a semiconductor substrate (102) having a first surface (1021) and a second surface (1022) opposite to the first surface (1021), wherein the semiconductor substrate (102) includes:
a first drift structure (104) comprising a drift region (1041) of a first conductivity type;
a channel region (106) of the first conductivity type adjoining, along a first lateral direction (x1), to first and second sub-regions (1081, 1082) of a control region (108) of a second conductivity type; and
a second drift structure (110) comprising a drift region (1101) of the first conductivity type; and wherein
the channel region (106) and the first and second sub-regions (1081, 1082) of the control region (108) are arranged, along a vertical direction (y), between the first drift structure (104) and the second drift structure (110).

2. The bi-directional JFET (100) of the preceding claim, further comprising
a first load electrode (D1) over the first surface (1021) of the semiconductor substrate (102), the first load electrode (D1) being electrically connected to the second drift structure (110); and
a second load electrode (D2) over the second surface (1022) of the semiconductor substrate (102), the second load electrode (D2) being electrically connected to the first drift structure (104).

3. The bi-directional JFET (100) of any of the preceding claims, wherein the first drift structure (104) further includes a compensation region (1042) of the second conductivity type, wherein the compensation region (1042) is electrically connected to the first and second sub-regions (1081, 1082) of the control region (108), the compensation region (1042) and the drift region (1041) of the first drift structure (104) forming a superjunction structure, SJ structure (SJ).

4. The bi-directional JFET (100) of any of the preceding claims, wherein first subregion (1081) is connected to the second subregion (1082) via a third sub-region (1083) of the control region (108), the first sub-region (1081), the second sub-region (1082), and the third sub-region (1083) defining a U-shaped control region (108).

5. The bi-directional JFET (100) of any of the preceding claims, further comprising a intermediate region (100) of the first conductivity type arranged between the first sub-region (1081) and the second sub-region (1082) of the control region (108) along the first lateral direction (x1).

6. The bi-directional JFET (100) of any of the preceding claims, further comprising a control contact trench structure (112) extending from the first surface (102) through the second drift structure (110), wherein the third sub-region (1083) of the control region (108) is electrically connected to a contact material (1121) of the control contact trench structure (112) via a bottom of the control contact trench structure (112).

7. The bi-directional JFET (100) of the preceding claim, wherein the control contact trench structure (112) includes the contact material (1121) and a dielectric fill material (1122) on the contact material (1121).

8. The bi-directional JFET (100) of any of the two preceding claims, wherein the contact material (1121) includes a metal or metal silicide at a bottom of the control contact trench structure (112).

9. The bi-directional JFET (100) of any of the three preceding claims, wherein the channel region extends along a second lateral direction (x2) perpendicular to the first lateral direction (x1), and a plurality of the control contact trench structures (112) are arranged with a lateral distance along the second lateral direction (x2).

10. The bi-directional JFET (100) of any of the four preceding claims, wherein the second drift structure (110) further includes a compensation region (1103) of the second conductivity type lining sidewalls of the control contact trench structure (112).

11. The bi-directional JFET (100) of any of the preceding claims, wherein, along the first lateral direction (x1), the channel region (106) includes first, second and third channel sub-regions having a same extent along the first lateral direction (x1), and a concentration of dopants of the first conductivity type averaged along the first lateral direction (x1) in the second channel sub-region is larger than a concentration of dopants of the first conductivity type averaged along the first lateral direction (x1) in each of the first and third channel sub-regions.

12. A method of manufacturing a bi-directional junction field-effect transistor, bi-directional JFET (100), the method comprising:
forming, in a semiconductor substrate (102) having a first surface (1021) and a second surface (1022) opposite to the first surface (1021):
a first drift structure (104) comprising a drift region (1041) of a first conductivity type;
a channel region (106) of the first conductivity type adjoining, along a first lateral direction (x1), to first and second sub-regions (1081, 1082) of a control region (108) of a second conductivity type; and
a second drift structure (110) comprising a drift region (1101) of the first conductivity type; and wherein
the channel region (106) and the first and second sub-regions (1081, 1082) of the control region (108) are arranged, along a vertical direction (y), between the first drift structure (104) and the second drift structure (110).

13. The method of the preceding claim, wherein forming the first and second sub-regions (1081, 1082) of the control region (108) includes
forming a trench (125) into a first semiconductor layer of the semiconductor substrate (102), the first semiconductor layer including the first drift structure (104); and
introducing dopants of the second conductivity type into the first semiconductor layer through sidewalls of the trench (125).

14. The method of the preceding claim, wherein the channel region (106) is a part of the first semiconductor layer that laterally adjoins to the first and second sub-regions (1081, 1082) of the control region (108), and wherein forming the channel region (106) further includes introducing dopants of the first conductivity type into the part of the first semiconductor layer through sidewalls of the trench.

15. The method of any of the three preceding claims, wherein the second drift structure (110) is formed by an epitaxial deposition process of a second semiconductor layer on the first semiconductor layer after forming the first and second sub-regions (1081, 1082) of the control region (108).
